# EUROPEAN PATENT APPLICATION

(11) **EP 2 381 462 A2**
(43) Date of publication of application: **26.10.2011**
(21) Application number: 11162415.1
(22) Date of filing: 14.04.2011
(51) Int. Cl.: H01J 37/304, H01J 37/317

(54) **Electron-beam exposure apparatus and method of manufacturing device**

(30) Priority: 20.04.2010 JP 2010097421; 01.04.2011 JP 2011082192
(71) Applicant: Canon Kabushiki Kaisha, Tokyo 146-8501 (JP)
(72) Inventor: Wataru, Yamaguchi, Tokyo Tokyo 146-8501 (JP)
(74) Representative: TBK

(57) **Abstract**

An electron-beam exposure apparatus (100) includes a first measurement device (4) which irradiates a mark formed on a substrate (6) with light to detect reflected light of the light, thereby measuring the position of the mark, a second measurement device (24) which detects a secondary electron generated by the electron beam guided from an electron source (21) onto the mark, thereby measuring the position of the mark, and a controller (7, 8, 10, 11). The controller performs measurements for the mark using the first and second measurement devices without interposing drawing of a pattern on the substrate with the electron beam between the measurements, calculates a shift in irradiated point of the electron beam based on the difference between the measurement results obtained by the first and second measurement devices, and controls at least one of a stage (2) and the electron optical system to correct the calculated shift.

## Description

### BACKGROUND OF THE INVENTION

### Field of the Invention

The present invention relates to an electron-beam exposure apparatus and a method of manufacturing a device.

### Description of the Related Art

In recent years, with an increase in packing density and miniaturization of semiconductor integrated circuits, the line width of a pattern formed on a substrate such as a wafer has become very small. In keeping with this trend, a finer pattern is desired to be transferred in a lithography process in which a pattern is formed on a wafer. An electron-beam exposure scheme is known as one method which meets this requirement for pattern miniaturization. In general, an electron-beam exposure apparatus converges an electron beam emitted by an electron gun on a desired position on a wafer via an electron optical system, and moves the electron beam relatively to a stage on which the wafer is mounted, thereby drawing a pattern on the wafer. Hence, to form a micropattern, it is of prime importance to align the relative position between the electron beam and the wafer with as high an accuracy as possible.

One factor which degrades the alignment accuracy between the electron beam and the wafer is a drift of the electron beam resulting from charge-up. In electron-beam exposure, charge-up of the electron optical system occurs due to a rise in temperature of the electron optical system and scattering of shielded electrons, and that of the wafer occurs upon electron beam irradiation. This causes a drift of the electron beam upon a shift in irradiation direction of the electron beam guided from the electron optical system onto the wafer or a change in electron beam trajectory due to factors associated with a global charge distribution on the wafer. This poses a problem in that the alignment accuracy in electron-beam exposure degrades, thus deteriorating the pattern processing accuracy.

To solve the problem resulting from a drift of an electron beam due to charge-up, the following techniques have been proposed. Japanese Patent Laid-Open No. 2001-168013 describes an electron-beam exposure apparatus which uses an electron detector that detects secondary electrons from a wafer to measure the position of an alignment mark formed on the wafer, thereby correcting a drift of an electron beam. The electron-beam exposure apparatus described in Japanese Patent Laid-Open No. 2001-168013 irradiates the alignment mark on the wafer with an electron beam at a predetermined timing after the start of drawing, and detects secondary electrons from the wafer to measure the position of the alignment mark. This apparatus calculates the amount of drift of the electron beam based on the difference from the previous measurement result, and superimposes the calculation result on the amount of deflection of the electron beam, thereby correcting the drift of the electron beam. Also, Japanese Patent Laid-Open No. 2000-049069 describes an electron-beam exposure apparatus which corrects a drift of an electron beam based on the position measurement result of an alignment mark obtained using light and the electron beam. The electron-beam exposure apparatus described in Japanese Patent Laid-Open No. 2000-049069 includes an electron detector which detects secondary electrons from the wafer upon scanning the alignment mark using an electron beam, and an alignment detection system which irradiates the alignment mark with light and receives the light reflected by it. The electron-beam exposure apparatus described in Japanese Patent Laid-Open No. 2000-049069 calculates the amount of drift of the electron beam based on the position of the alignment mark measured using the light only once before the start of drawing, and that measured using the electron beam after the start of drawing. This apparatus corrects the position to which the electron beam is deflected or the stage position, based on the calculated amount of drift, thereby correcting the exposure position of the electron beam.

However, in the method of calculating a drift of an electron beam based on a comparison between the position measurement results of an alignment mark, which are obtained before and after the start of drawing, drawing is interposed between two position measurement operations for calculation, and these operations have a time lag between them accordingly. As a result, an error occurs in the calculated amount of drift of the electron beam due to substrate deformation or expansion/contraction resulting from, for example, a change in temperature and other factors associated with the drawing interposed between the two position measurement operations. Therefore, it is difficult to precisely calculate the amount of drift of an electron beam using the method of calculating the amount of drift of an electron beam based on the difference from the previous position measurement result using light and the electron beam, as in Japanese Patent Laid-Open Nos. 2001-168013 and 2000-049069.

### SUMMARY OF THE INVENTION

In view of this, the present invention provides an electron-beam exposure apparatus which can precisely draw a pattern on a substrate by irradiating the substrate with an electron beam free from any shift.

The present invention in its first aspect provides an electron-beam exposure apparatus as specified in claims 1 to 5.

The present invention in its second aspect provides a method of manufacturing a device as specified in claim 6.

Further features of the present invention will become apparent from the following description of exemplary embodiments with reference to the attached drawings.

### BRIEF DESCRIPTION OF THE DRAWINGS

Fig. 1 is a view showing the arrangement of an electron-beam exposure apparatus according to the present invention;

Fig. 2 is a view for explaining a drift of an electron beam;

Fig. 3 is a view for explaining the relationship between the array coordinate system of pattern regions and the stage coordinate system;

Fig. 4 is a flowchart of an electron-beam exposure method according to the first embodiment;

Fig. 5 is a view for explaining an electron-beam exposure scheme of drawing a pattern for each stripe with an electron beam;

Fig. 6 is a flowchart of an electron-beam exposure method according to the second embodiment; and

Fig. 7 is a flowchart of an electron-beam exposure method according to the third embodiment.

### DESCRIPTION OF THE EMBODIMENTS

Embodiments of the present invention will be described in detail below with reference to the accompanying drawings. Note that the same reference numerals denote the same members throughout the drawings, and a repetitive description thereof will not be given. Also, although an electron-beam exposure apparatus which draws a pattern with a single electron beam alone will be described in the following embodiments, the number of electron beams is not always limited to this. The present invention is also applicable to, for example, a multibeam electron-beam exposure apparatus which draws a pattern with a plurality of electron beams, as a matter of course.

### [First Embodiment]

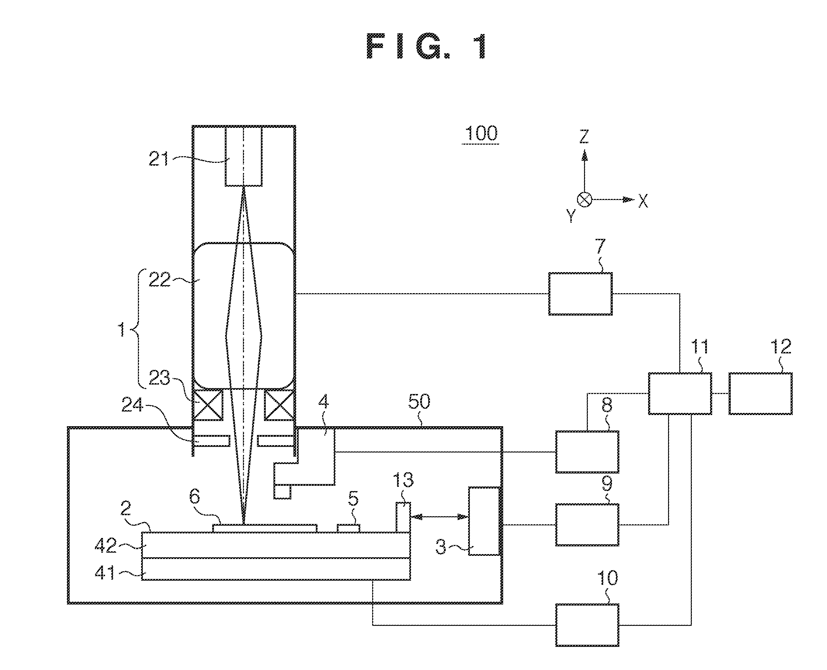

Fig. 1 is a view showing the arrangement of an electron-beam exposure apparatus 100 which draws a pattern on a substrate with an electron beam according to the present invention. The electron-beam exposure apparatus 100 principally includes an electron source (electron gun) 21, an electron optical system 1, an electron detector 24, a stage (wafer stage) 2 which holds a substrate (wafer) 6, an interferometer 3, an alignment optical system 4, and a vacuum chamber 50. The electron source 21 emits an electron beam onto the wafer 6. The electron optical system 1 forms an image of the electron beam on the surface of the wafer 6. The alignment optical system 4 serves as a first measurement device which irradiates a mark on the wafer 6 and a reference mark formed on the wafer stage 2 with light beams to detect reflected light beams of the light beams with which these marks are irradiated, thereby measuring the positions of these marks with reference to the optical axis (first reference). The electron detector 24 serves as a second measurement device which detects secondary electrons generated by the electron beam guided from the electron source 21 onto the mark on the wafer 6 and the reference mark via the electron optical system 1, thereby measuring the positions of these marks with reference to a reference axis (second reference). The vacuum chamber 50 is evacuated to a vacuum by a vacuum pump (not shown). The electron gun 21, electron optical system 1, electron detector 24, wafer stage 2, interferometer 3, and alignment optical system 4 are located in the vacuum chamber 50.

The electron optical system 1 includes an electron lens system 22 which converges the electron beam from the electron gun 21, and a deflector 23 which deflects the electron beam. An electron optical system controller 7 controls the electron gun 21, electron optical system 1, and electron detector 24. In drawing a pattern on the substrate (wafer) 6 using an electron beam, the electron optical system controller 7 scans the electron beam using the deflector 23, and controls electron beam irradiation in accordance with the pattern to be drawn. In measuring the position of the wafer 6 using an electron beam, the electron optical system controller 7 scans the electron beam on the wafer 6 using the deflector 23, and detects secondary electrons from the wafer 6 using the electron detector 24 to obtain the position of the wafer 6.

The wafer stage 2 has an arrangement in which an X stage 42 is mounted on a Y stage 41, and the wafer 6 coated with a photosensitive material is held on the X stage 42. A reference plate 5 on which a reference mark SM is formed is provided on the X stage 42 at a position different from that of the wafer 6, and an X-axis moving mirror 13 is provided on the X stage 42 at its one end in the X direction. The Y stage 41 positions the wafer 6 in the Y direction perpendicular to the paper surface of Fig. 1 within a plane perpendicular to a second reference AX1 of the electron lens system 22. The X stage 42 positions the wafer 6 in the X direction perpendicular to the Y-axis within the plane perpendicular to the second reference AX1 of the electron lens system 22. A Z stage (not shown) which positions the wafer 6 in the Z direction parallel to the second reference AX1 of the electron lens system 22, for example, is also mounted on the X stage 42. A wafer stage controller 10 controls the Y stage 41 and X stage 42.

The interferometer 3 splits a laser beam emitted by a laser light source provided in it into measurement light and reference light. The interferometer 3 guides the measurement light onto the X-axis moving mirror 13 provided on the wafer stage 2 and the reference light onto a reference mirror provided inside the interferometer 3 to superpose the reflected measurement light and reference light on each other so that they interfere with each other, and detects the intensity of the interfering light using a detector. Because the measurement light and the reference light have frequencies different from each other only by a small amount Δf at the time of emission, the detector outputs a beat signal with a frequency which has a change Δf in accordance with the moving velocity of the X-axis moving mirror 13 in the X direction. A stage position detection unit 9 processes this beat signal, thereby measuring, with a high resolution and high accuracy, the amount of change in optical path length of the measurement light with reference to the optical path length of the reference light, that is, the X-coordinate of the X-axis moving mirror 13 with reference to the reference mirror. Similarly, an interferometer (not shown) which detects, with a high resolution and high accuracy, the position of the wafer stage 2 in the Y direction measures the Y-coordinate of a moving mirror, provided on the wafer stage 2, with reference to a reference mirror. The alignment optical system 4 guides non-exposure light onto an alignment mark formed on the wafer 6 or wafer stage 2 to form an image of the light reflected by it on a sensor, thereby detecting an image of the alignment mark. An alignment optical system controller 8 obtains the position of the alignment mark with respect to an optical axis AX2 of the alignment optical system 4. A main controller 11 processes the data from the electron optical system controller 7, alignment optical system controller 8, stage position detection unit 9, and wafer stage controller 10 to issue, for example, a command to each of these controllers. A memory 12 stores information necessary for the main controller 11. The main controller 11, electron optical system controller 7, alignment optical system controller 8, and wafer stage controller 10 serve as a controller.

Although the electron-beam exposure apparatus 100 basically draws patterns at a plurality of shot positions on the wafer 6 side by side by a step-and-repeat operation, it may draw a pattern by scanning the wafer 6 and deflecting the electron beam. In drawing a pattern on the wafer 6 mounted on the wafer stage 2 by deflecting the electron beam, the reference position of the electron beam with respect to the wafer 6 is corrected by controlling the deflector 23 which deflects the electron beam or controlling the position of the wafer stage 2, in accordance with the characteristics of movement of the wafer stage 2. The electron-beam exposure apparatus 100 according to the first embodiment sequentially measures the position of the set alignment mark using the alignment optical system 4 and electron detector 24 without interposing a drawing operation which uses an electron beam between the two position measurement operations. The electron-beam exposure apparatus 100 calculates the amount of drift of the electron beam corresponding to the coordinate position on the wafer 6, based on the measurement results obtained by the alignment optical system 4 and electron detector 24. This makes it possible to reduce a shift in measured value resulting from deformation or expansion/contraction of the wafer 6. The reason for this will be explained in detail later.

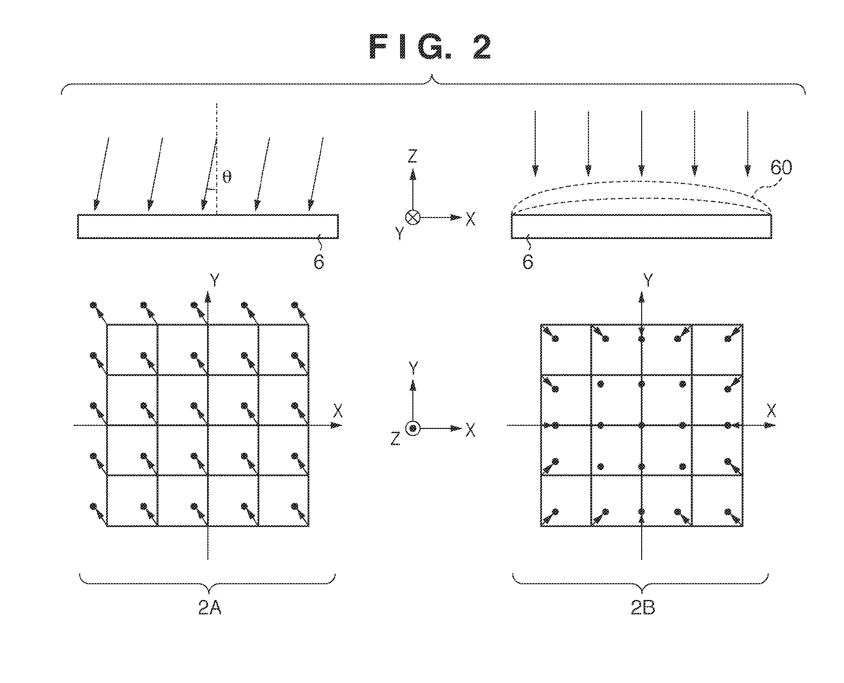

A drift of the electron beam resulting from charge-up of the electron optical system 1 and wafer 6 in the electron-beam exposure apparatus 100 will be described with reference to Fig. 2. Fig. 2 shows changes in exposure position of the electron beam resulting from charge-up of the electron optical system 1 and that of the wafer 6, respectively, in the electron-beam exposure apparatus 100. As shown in part 2A of Fig. 2, when charge-up of the electron optical system 1 occurs, the electron beam and the Z-axis have a tilt angle θ between them, so a shift in exposure position occurs on the X-Y plane. The shift in exposure position due to charge-up of the electron optical system 1 serves as a second component of a drift corresponding to a shift in electron beam, which is independent of the irradiated point of the electron beam. On the other hand, as shown in part 2B of Fig. 2, when charge-up of the wafer 6 occurs, the Z-axis and an equipotential surface 60 are orthogonal to each other at the central portion of the wafer 6 but have a tilt between them on the outer edge portion of the wafer 6. This is because the wafer peripheral portion is normally grounded by a metal. Thus, the amount of drift of the electron beam resulting from charge-up of the wafer 6 becomes relatively large on the outer edge portion of the wafer 6, as shown in the part 2B of Fig. 2. The shift in exposure position due to charge-up of the wafer 6 serves as a first component of the drift corresponding to the shift in electron beam, which depends on the irradiated point of the electron beam. The charge-up of the electron optical system 1 and that of the wafer 6 increase with time, so the amounts of drift of the electron beam shown in Fig. 2 also increase with time. Therefore, if drawing is performed with no concern for a drift of the electron beam, a shift in irradiated point (exposure position) of the electron beam occurs by the amount of drift, and the alignment accuracy between the electron beam and the wafer 6 degrades.

Another factor which degrades the alignment accuracy between the electron beam and the wafer 6 is deformation or expansion/contraction of the wafer 6 resulting from, for example, a change in temperature. In the electron-beam exposure apparatus, deformation or expansion/contraction of the wafer 6 generally occurs due to the influence of, for example, a change in temperature during a drawing operation. Therefore, as time elapses by the drawing operation, the relative position between the electron beam and the wafer 6 changes. In the conventional method of measuring the position of the alignment mark using the alignment optical system 4 and electron detector 24 while interposing a drawing operation between the two position measurement operations, and calculating the amount of drift of the electron beam based on a comparison between the two measurement results, time elapses by the drawing operation between the two position measurement operations for calculation. Therefore, the calculated amount of drift of the electron beam includes a shift in measured value due to wafer deformation or expansion/contraction resulting from, for example, a change in temperature, so the alignment accuracy between the electron beam and the wafer degrades as the accuracy of electron beam drift correction degrades.

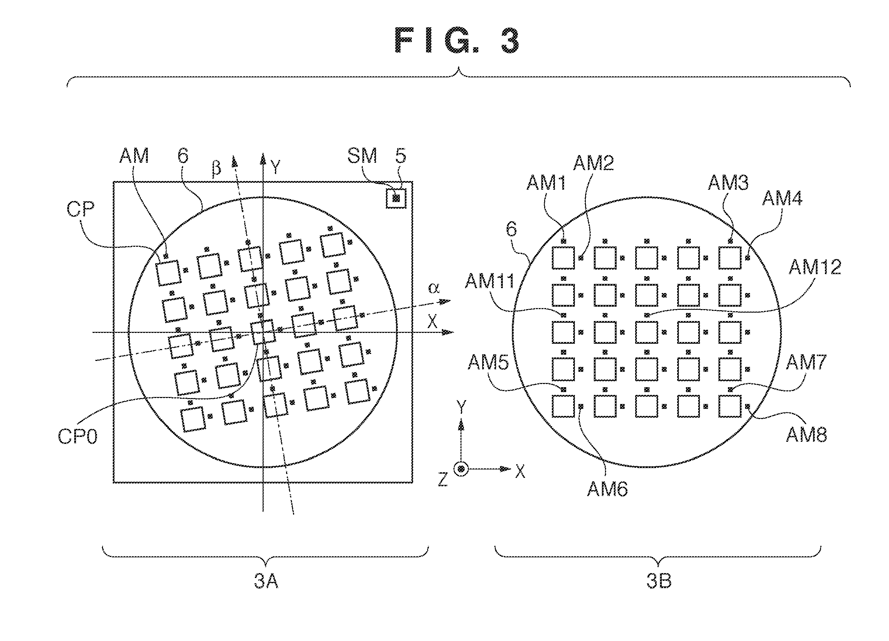

The drawing operation of the electron-beam exposure apparatus 100 in the first embodiment will be described next. A shift in measured value occurs in calculating the amount of drift of the electron beam due to deformation or expansion/contraction of the wafer 6 resulting from, for example, a change in temperature, so the alignment accuracy between the electron beam and the wafer 6 degrades, as has been described earlier. The electron-beam exposure apparatus 100 according to the first embodiment measures the positions of a plurality of alignment marks using the alignment optical system 4 and electron detector 24 at predetermined timings after the start of drawing, and calculates the amount of drift of the electron beam corresponding to the coordinate position on the wafer 6 based on the measurement results. Prior to a detailed description, a coordinate system in the first embodiment will be described with reference to Fig. 3. A plurality of rectangular pattern regions CP are formed on the wafer 6, mounted on the X stage 42, in a matrix pattern to match an array coordinate system αβ, as shown in part 3A of Fig. 3. Each pattern region CP is defined to overlap a pattern drawn with the electron beam, and alignment marks AM for use in alignment in the X and Y directions are formed in association with them. Note that the origin of the array coordinate system αβ is defined to coincide with the central point of a pattern region CP0 positioned near the center on the wafer 6. The design coordinate values of each pattern region CP in the array coordinate system αβ are stored in the memory 12 shown in Fig. 1 in advance. Part 3B of Fig. 3 is a view showing an example of an array of alignment marks AM on the wafer 6. Alignment marks AM1 to AM8 are used to decide the array regularity of pattern regions CP. A plurality of alignment marks AM11 and AM12 are used to decide the amount of drift of the electron beam. The alignment mark AM11 serves as a first mark formed on the peripheral portion of the substrate, and the alignment mark AM12 serves as a second mark formed at the central portion of the substrate.

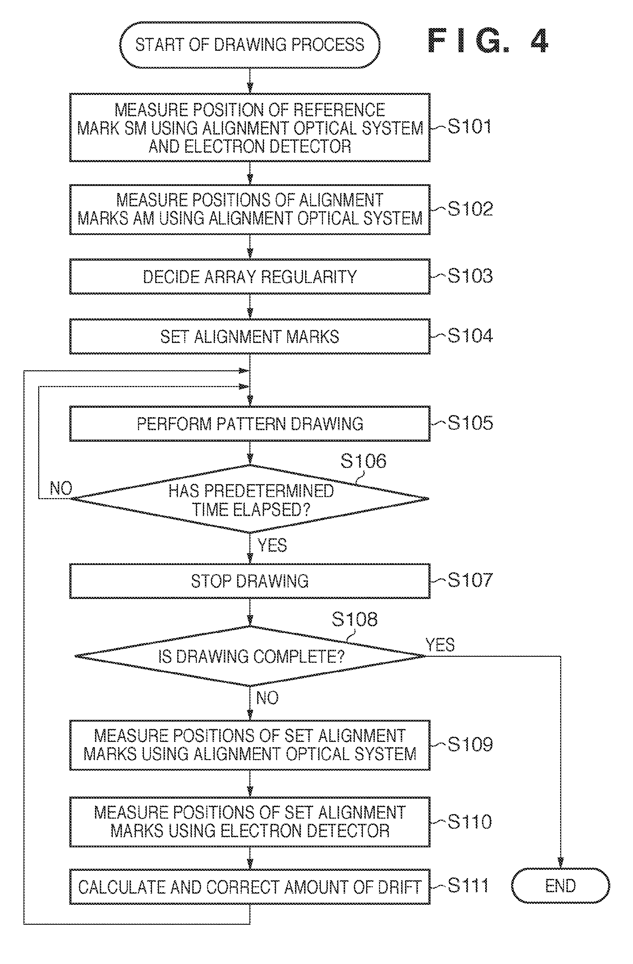

As a drawing process starts, the electron-beam exposure apparatus 100 executes the following steps in accordance with a drawing process flowchart shown in Fig. 4. In step S101, the wafer stage controller 10 moves the wafer stage 2 so that the reference mark SM is positioned on the optical axis AX2 of the alignment optical system 4, based on the design coordinate position of the reference mark SM in the stage coordinate system. The alignment optical system controller 8 detects a positional shift of the reference mark SM with respect to the optical axis AX2. Based on the detected positional shift, the main controller 11 resets the stage coordinate system, defined by the stage position detection unit 9, such that the origin of the X-Y stage coordinate system coincides with the optical axis AX2. The wafer stage controller 10 moves the wafer stage 2 so that the reference mark SM is positioned on the measurement reference axis (second reference) AX1 of the electron lens system 22, based on the design positional relationship between the reference axis AX1 of the electron lens system 22 and the optical axis AX2 of the alignment optical system 4. The electron optical system controller 7 scans the reference mark SM using an electron beam to detect a positional shift of the reference mark SM, and the main controller 11 decides a baseline between the reference axis AX1 and the optical axis AX2.

In step S102, the wafer stage controller 10 moves the wafer stage 2 so that the alignment marks AM1 to AM8 selected from the alignment marks AM on the wafer 6 are positioned on the optical axis AX2 of the alignment optical system 4, based on their design coordinate positions. The alignment optical system controller 8 detects positional shifts of the alignment marks AM1 to AM8 with respect to the optical axis AX2 to obtain actual measured values for the alignment marks AM1 to AM8 from their amounts of positional shift and design coordinate positions. In step S103, the main controller 11 calculates a shift, a magnification, and a rotation for the array of pattern regions CP within the plane of the wafer 6 by the global alignment method using the measurement results obtained in step S102 to decide the array regularity of pattern regions CP. The main controller 11 calculates a correction coefficient from the baseline and the decided array regularity, and performs alignment based on the calculation result. The correction coefficient calculated herein is stored in the memory 12 by the main controller 11. In step S104, the main controller 11 selects and sets the plurality of alignment marks AM11 and AM12, which are to be measured for electron beam drift correction, from the alignment marks AM on the wafer 6.

In step S105, the main controller 11 activates at least one of the deflector 23 and the wafer stage 2 so that the electron beam is aligned with the position within each pattern region CP to start drawing of a pattern corresponding to the design values of the pattern region CP. In step S106, the main controller 11 determines whether a predetermined time has elapsed, and continuously performs the pattern drawing until the predetermined time elapses. In step S107, the main controller 11 stops the drawing operation a predetermined time after its start. If drawing in all drawing regions on the wafer 6 is complete in step S108, the main controller 11 ends the drawing on the wafer 6. On the other hand, if drawing in all drawing regions on the wafer 6 is incomplete in step S108, the process advances to step S109. In step S109, the wafer stage controller 10 moves the wafer stage 2 so that the alignment marks AM11 and AM12 set in step S104 are positioned on the optical axis AX2 of the alignment optical system 4, based on the array regularity decided in step S103. The alignment optical system controller 8 detects positional shifts of the alignment marks AM11 and AM12 with respect to the optical axis AX2. In step S110, the wafer stage controller 10 moves the wafer stage 2 so that the alignment marks AM11 and AM12 are positioned on the reference axis AX1 of the electron lens system 22, based on the baseline calculated in step S101. The electron detector 24 measures the positions of the alignment marks AM11 and AM12 using an electron beam, and the electron optical system controller 7 detects positional shifts of the alignment marks AM11 and AM12 with respect to the reference axis AX1. In step S111, the main controller 11 respectively calculates the amounts of drift of the electron beam for the alignment marks AM11 and AM12 from the differences between the measurement results obtained by the electron optical system controller 7 and alignment optical system controller 8. The main controller 11 calculates the amount of drift of the electron beam corresponding to the coordinate position of the wafer 6 using a function defined in the coordinate system on the wafer 6, based on the coordinate positions of the alignment marks AM11 and AM12 and the amounts of drift obtained for these marks. The main controller 11 issues a command to the electron optical system controller 7 or wafer stage controller 10 to adjust the position to which the electron beam is deflected or the position of the wafer stage 2, based on the calculated amount of drift, thereby correcting the drift of the electron beam. After the end of the calculation and correction of the amount of drift of the electron beam in step S111, the process returns to step S105, in which pattern drawing restarts. These drawing processes continue until drawing on all chips on the wafer 6 is completed in step S108. When drawing is complete in step S108, all the processes end.

In the first embodiment, before the start of drawing, the main controller 11 selects and sets the plurality of alignment marks AM11 and AM12, which are used to decide the amount of drift, from the plurality of alignment marks AM (S104). The main controller 11 stops the drawing operation a predetermined time after its start, and the alignment optical system 4 and electron detector 24 sequentially measure the positions of the set alignment marks AM11 and AM12 without interposing a drawing operation between the two position measurement operations. The main controller 11 calculates the amount of drift of the electron beam based on the measurement results obtained by the electron optical system controller 7 and alignment optical system controller 8. That is, the main controller 11 calculates the amount of drift of the electron beam from the difference between the position measurement result obtained using an electron beam which suffers from a drift due to charge-up of the electron optical system 1 and wafer 6 and that obtained using light which is free from the influence of this charge-up. Thus, the time lapses of a drawing operation between two position measurement operations using the alignment optical system 4 and electron detector 24, respectively, are extremely short for the electron-beam exposure apparatus 100 in comparison with conventional electron-beam exposure apparatuses. For example, the time interval between the two position measurement operations for calculation is about 10 min in the conventional electron-beam exposure apparatus while it is 10 sec or less in this embodiment. Therefore, the electron-beam exposure apparatus 100 can reduce a shift in measured value resulting from deformation or expansion/contraction of the wafer 6 as compared with the conventional electron-beam exposure apparatus. This makes it possible to accurately decide and correct the amount of drift of the electron beam resulting from charge-up of the electron optical system 1 and wafer 6, thereby aligning the electron beam and the wafer 6 with high accuracy.

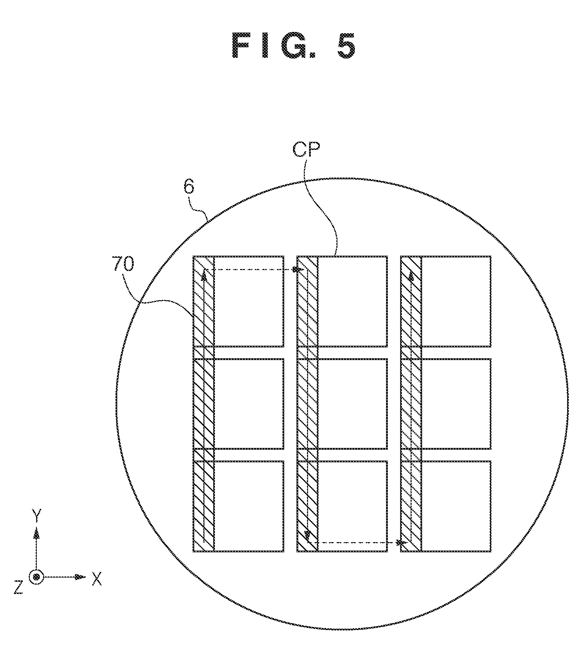

A method of setting alignment marks to be set in step S104 of Fig. 4 will be described. In the electron-beam exposure apparatus 100, the refractive index of the resist applied on the surface of the wafer 6 changes upon electron beam irradiation, so a difference may occur between the measurement results obtained by the alignment optical system controller 8 before and after the electron beam irradiation. Therefore, if a drift of an electron beam is corrected using alignment marks irradiated with the electron beam even once, the accuracy of electron beam drift correction may degrade due to a shift in position measurement result obtained by the alignment optical system 4. The electron beam irradiation includes that in pattern drawing and that in measuring the positions of the alignment marks by the electron detector 24. Hence, when alignment marks used to decide the amount of drift are set in step S104, the main controller 11 selects alignment marks which are not irradiated with an electron beam after the wafer 6 is placed on the wafer stage 2. In view of this, in this embodiment, the main controller 11 sets alignment marks before the start of pattern drawing, in consideration of, for example, regions irradiated with the electron beam upon the operations in steps S105 to S110 and their order of irradiation. The main controller 11 calculates the amount of drift of the electron beam by performing position measurement operations in steps S109 and S110 using the alignment marks which are not irradiated with the electron beam. An electron-beam exposure scheme of drawing a pattern for each stripe is available as another method of selecting and setting alignment marks which are not irradiated with an electron beam. As shown in Fig. 5, the rectangular pattern regions CP are formed on the wafer 6, and patterns are drawn in stripe regions 70 in directions indicated by arrows with an electron beam. Therefore, by drawing stripes including the alignment marks after stripes including no alignment marks are drawn, irradiation of the alignment marks with the electron beam can be avoided. This makes it possible to relax constraints on setting alignment marks, thereby accurately calculating the amount of drift of the electron beam based on the position measurement results obtained by the electron detector 24 and alignment optical system 4.

The measurement for the plurality of alignment marks set in steps S109 and S110 will be described in more detail. In steps S109 and S110, the positions of the plurality of alignment marks AM1 and AM2 are measured using the alignment optical system 4 and electron detector 24. In this embodiment, to measure the positions of the alignment marks AM1 and AM2, position measurement which uses the electron detector 24 is performed after that which uses the alignment optical system 4 is performed. Assume that position measurement which uses the electron detector 24 is performed first. In this case, as described earlier, the refractive index of the resist applied on the surface of the wafer 6 changes upon electron beam irradiation, so a shift may occur in the measurement result obtained by the alignment optical system controller 8, thus deteriorating the measurement accuracy of a drift of the electron beam. However, when the positions of the set alignment marks AM1 and AM2 are measured using the alignment optical system 4 before they are measured using the electron detector 24, the amount of drift of the electron beam can be measured with high accuracy. Although the positions of the plurality of set alignment marks are measured using the electron detector 24 after they are measured using the alignment optical system 4 in this embodiment, the present invention is not limited to this. For example, the positions of a plurality of alignment marks may be measured in the following way. First, the position of a single alignment mark is measured using both the alignment optical system 4 and electron detector 24. Next, the position of another alignment mark is measured using both the alignment optical system 4 and electron detector 24.

The calculation of the amount of drift of the electron beam in step S111 will be described in more detail. In step S111, based on the measurement results obtained in steps S109 and S110 by the alignment optical system controller 8 and electron optical system controller 7, respectively, the main controller 11 calculates and decides drifts of the electron beam resulting from charge-up of the electron optical system 1 and that of the wafer 6, respectively. In this embodiment, one alignment mark AM12 of the plurality of alignment marks set in step S104 is positioned at the central portion of the wafer 6, and is therefore less subject to charge-up of the wafer 6, as shown in the part 2B of Fig. 2. Hence, the amount of drift of the electron beam resulting from charge-up of the electron optical system 1 can be calculated and decided from the difference between the measurement results of the alignment mark AM12 obtained by the electron optical system controller 7 and alignment optical system controller 8. This amount of drift of the electron beam resulting from charge-up of the electron optical system 1 serves as a second component of a shift in irradiated point of the electron beam, which is independent of the irradiated point. On the other hand, the difference between the measurement results of the alignment mark AM11 positioned on the periphery of the wafer 6, which are obtained by the electron optical system controller 7 and alignment optical system controller 8, includes the influence of charge-up of both the electron optical system 1 and the wafer 6. Hence, the value obtained by subtracting the previously obtained amount of drift of the electron beam resulting from charge-up of the electron optical system 1 from the amount of drift of the electron beam calculated using the alignment mark AM11 represents the amount of drift of the electron beam resulting from charge-up of the wafer 6. This amount of drift of the electron beam resulting from charge-up of the wafer 6 serves as a first component of the shift in irradiated point of the electron beam, which depends on the irradiated point. Since the charge-up of the wafer 6 depends on the position on the wafer plane, the main controller 11 calculates the amount of drift of the electron beam corresponding to the coordinate position of the wafer 6 using a function defined in the coordinate system on the wafer 6, based on the coordinate position of the alignment mark AM11. After that, electron beam drift correction is performed based on the calculated amount of drift. The main controller 11 issues a command to the electron optical system controller 7 or wafer stage controller 10 to adjust the position to which the electron beam is deflected or the position of the wafer stage 2, based on the calculated amount of drift. At this time, drifts of the electron beam resulting from charge-up of the electron optical system 1 and that of the wafer 6, respectively, may be discriminated from each other to adjust the position to which the electron beam is deflected or the position of the wafer stage 2, thereby correcting the drift of the electron beam.

Although the two alignment marks AM11 and AM12 which align themselves in the X-axis direction are set, as shown in the part 3B of Fig. 3, in this embodiment, the number and positions of set alignment marks and the method of calculating the amount of drift are not limited to this case. For example, three or more alignment marks may be set, and the amount of drift of the electron beam may be calculated by polynomial approximation based on the amounts of drift, which are respectively measured using these alignment marks. Also, alignment marks may be selected and set from the alignment marks AM1 to AM8 having undergone position measurement operations in order to decide the array regularity in step S102. Nevertheless, in this case, the optical measurement accuracy may degrade due to a change in refractive index of the resist upon electron beam irradiation, so the array regularity is desirably decided using alignment marks other than the set alignment marks to perform drawing again.

The relationship between the numbers of alignment mark measurement points used by the alignment optical system 4 and electron detector 24 will be described next. In this embodiment, the regularity of a chip array is decided from the alignment mark position measurement result obtained using the alignment optical system 4, and the amount of drift of the electron beam is calculated from the alignment mark position measurement results obtained by the alignment optical system 4 and electron detector 24. That is, the alignment mark position measurement result obtained by the alignment optical system 4 is used as a reference for alignment between the electron beam and the wafer. Hence, the alignment optical system 4 uses alignment mark measurement points more than those used by the electron detector 24. If the alignment mark position measurement result obtained by the electron detector 24 is used as a reference for alignment, the electron detector 24 uses alignment mark measurement points more than those used by the alignment optical system 4.

In general, measurement of the positions of alignment marks on a wafer using an electron beam has the problem that sufficient accuracy cannot be achieved when a portion irradiated with the electron beam after its development is patterned and alignment is performed using the same alignment marks in the next drawing process. Hence, for high-accuracy alignment, it is necessary to perform position measurement using different alignment marks for each drawing process. This increases the number of alignment marks to be formed on the wafer. However, only a finite number of alignment marks can be formed on the wafer because of a space limit on a scribe line defined on the wafer, so the degree of integration of chips on the wafer decreases when alignment marks are formed in excess of this limit. For the foregoing reason, as the number of alignment marks which undergo position measurement using an electron beam increases, the trouble of forming alignment marks may increase and the degree of integration of chips may decrease. To avoid this, the electron-beam exposure apparatus 100 according to this embodiment uses the alignment mark position measurement result obtained by the alignment optical system 4 as a reference for alignment between the electron beam and the wafer 6, thereby suppressing an increase in number of alignment marks to be formed on the wafer 6.

According to this embodiment, after the start of a drawing operation, the positions of a plurality of alignment marks set among the alignment marks AM formed on the wafer 6 are sequentially measured using the alignment optical system 4 and electron detector 24. The main controller 11 calculates the amount of drift of the electron beam based on the difference between the measurement results obtained by the alignment optical system controller 8 and electron optical system controller 7, and corrects the position to which the electron beam is deflected or the position of the wafer stage 2. Thus, the lapse of time between two position measurement operations for calculating the amount of drift can be extremely shorter in the electron-beam exposure apparatus according to this embodiment than in the conventional electron-beam exposure apparatuses described in Japanese Patent Laid-Open Nos. 2001-168013 and 2000-049069. This reduces the influence of deformation or expansion/contraction of the wafer 6 resulting from, for example, a change in temperature, thereby making it possible to measure and correct, with high accuracy, the amount of drift of the electron beam which changes with time. According to this embodiment, it is possible to provide an electron-beam exposure apparatus which can align the electron beam and the wafer 6 with high accuracy. Although the timing at which the amount of drift of the electron beam is measured is set to every predetermined time in this embodiment, the present invention is not limited to this, and this timing may be set to, for example, the timing of the end of drawing for every chip, that of the end of drawing for every line, or that of the end of drawing for every stripe. Also, the timing at which the amount of drift of the electron beam is measured may be changed in accordance with characteristics of detection.

### [Second Embodiment]

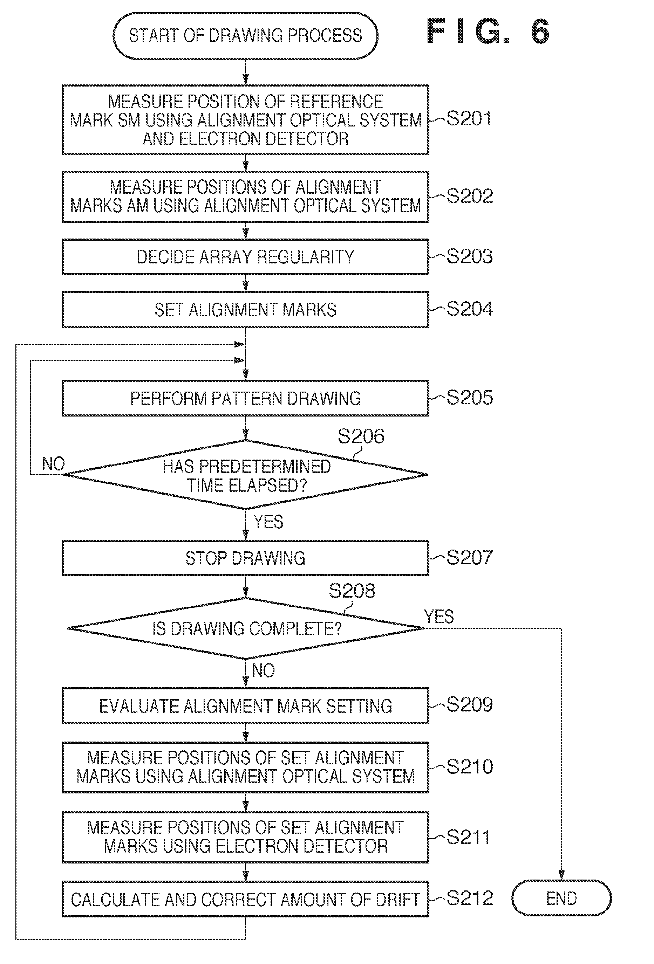

An electron-beam exposure method according to the second embodiment will be described with reference to Fig. 6. Fig. 6 is a flowchart of an electron-beam exposure method according to the second embodiment. As a drawing process starts, an electron-beam exposure apparatus 100 shown in Fig. 1 executes the following steps in accordance with the drawing process flowchart shown in Fig. 6. Note that details of steps S201 to S208 in Fig. 6 are the same as those in steps S101 to S108, respectively, in Fig. 4, and a description thereof will not be given herein.

In step S209, for the second and subsequent alignment mark position measurement operations, a main controller 11 evaluates the calculation result of a shift in irradiated point of the electron beam based on the plurality of alignment marks set in step S204. If the main controller 11 determines that the calculation result is inappropriate, it newly selects and resets a different set of alignment marks, which are used to calculate the amount of drift, from alignment marks AM. In step S210, a wafer stage controller 10 moves a wafer stage 2 so that the different set of a plurality of alignment marks is positioned on an optical axis AX2 of an alignment optical system 4, based on the array regularity decided in step S203. An alignment optical system controller 8 detects positional shifts of the reset different set of alignment marks with respect to the optical axis AX2. In step S211, the wafer stage controller 10 moves the wafer stage 2 so that the reset different set of alignment marks is positioned on a reference axis AX1 of an electron lens system 22, based on the baseline calculated in step S201. An electron optical system controller 7 measures the positions of the reset different set of alignment marks using an electron beam to detect positional shifts of the set alignment marks with respect to the reference axis AX1. In step S212, the main controller 11 respectively calculates the amounts of drift of the electron beam for the reset different set of alignment marks from the difference between the measurement results obtained by the electron optical system controller 7 and alignment optical system controller 8. The main controller 11 calculates the amount of drift of the electron beam corresponding to the coordinate position of a wafer 6 using a function defined in the coordinate system on the wafer 6, based on the coordinate positions of the alignment marks and the amounts of drift obtained for these marks. The main controller 11 issues a command to the electron optical system controller 7 or wafer stage controller 10 to adjust the position to which the electron beam is deflected or the position of the wafer stage 2, based on the calculated amount of drift, thereby correcting the drift of the electron beam. After the end of the calculation and correction of the amount of drift of the electron beam in step S212, the process returns to step S205, in which pattern drawing restarts. These drawing processes continue until drawing on all chips on the wafer 6 is completed in step S208. When drawing is complete in step S208, all the processes end.

In this embodiment, before the start of drawing, the main controller 11 selects and sets a plurality of alignment marks from the alignment marks AM (S204). The main controller 11 stops the drawing operation a predetermined time after its start. When the second and subsequent alignment mark position measurement operations are to be performed, the main controller 11 determines the validity of the alignment mark setting in step S204. The main controller 11 determines the validity of the drift correction result using the alignment marks set in step S204, and it again selects and resets a different set of alignment marks from the alignment marks AM if the electron beam drift correction is unsatisfactory. After that, the main controller 11 sequentially measures the positions of the reset alignment marks using the alignment optical system 4 and an electron detector 24, and calculates the amount of drift of the electron beam based on the measurement results obtained by the electron optical system controller 7 and alignment optical system controller 8. Therefore, the difference from the first embodiment lies in that the validity of alignment mark setting is determined at a predetermined timing after the start of drawing, and alignment marks to be used are selected again and reset if the electron beam drift correction is unsatisfactory. The effect of this feature will be described below.

A high-order component corresponding to the coordinate position on the wafer 6 often occurs in a drift of the electron beam resulting from charge-up of an electron optical system 1 and the wafer 6 in the electron-beam exposure apparatus 100. Hence, to correct a drift of the electron beam with high accuracy, it is of prime importance to precisely obtain a drift of a high-order component. Note that to obtain a drift of a high-order component, it is necessary to increase the number of alignment marks for use in position measurement or adjust the positions of set alignment marks. In the first embodiment, in step S104 of Fig. 4, the main controller 11 sets alignment marks for use in position measurement in order to correct a drift of the electron beam before the start of pattern drawing. This makes it impossible to change the number and positions of alignment marks after the start of drawing. Therefore, upon the occurrence of a drift of a high-order component after the start of drawing, if the number or positions of alignment marks for use in position measurement are inappropriate, a drift of the electron beam may not be able to be accurately corrected. On the other hand, in this embodiment, the validity of alignment mark setting is determined at a predetermined timing after the start of drawing. Hence, even if the electron beam drift correction is unsatisfactory upon the occurrence of a drift of a high-order component, a drift of the electron beam can be corrected with high accuracy by re-evaluating the number and positions of alignment marks for each drawing process in position measurement. As for methods of setting and measuring alignment marks and those of calculating and correcting the amount of drift of the electron beam, the same details as described in the first embodiment are applicable to the second embodiment intact, and a description thereof will not be given.

In the drift correction method according to this embodiment as well, the lapse of time between two position measurement operations for calculating the amount of drift can be shorter than the conventional methods described in Japanese Patent Laid-Open Nos. 2001-168013 and 2000-049069. This reduces the influence of deformation or expansion/contraction of the wafer 6 resulting from, for example, a change in temperature, thereby making it possible to measure and correct, with high accuracy, the amount of drift of the electron beam which changes with time. According to this embodiment, it is possible to provide an electron-beam exposure apparatus which can align the electron beam and the wafer 6 with high accuracy.

### [Third Embodiment]

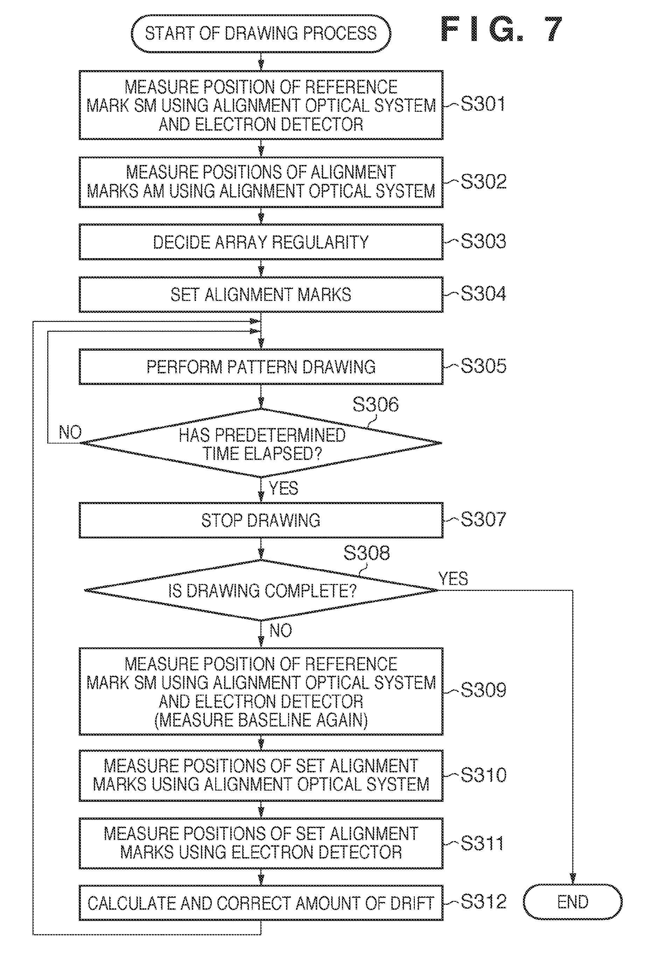

An electron-beam exposure method according to the third embodiment will be described with reference to Fig. 7. As a drawing process operation starts, an electron-beam exposure apparatus 100 shown in Fig. 1 executes the following steps in accordance with the drawing process flowchart shown in Fig. 7. Note that details of steps S301 to S303 and S305 to S308 in Fig. 7 are the same as those in steps S101 to S103 and S105 to S108, respectively, in Fig. 4, and a description thereof will not be given herein.

In step S304, a main controller 11 selects and sets an alignment mark AM11 (first mark), which is positioned on the peripheral portion of a wafer 6, from alignment marks AM on the wafer 6 (Fig. 3). A method of setting an alignment mark will be described in detail later. In step S309, a wafer stage controller 10 moves a wafer stage 2 so that a reference mark SM is positioned on an optical axis AX2 of an alignment optical system 4, based on the coordinate position of the reference mark SM in the stage coordinate system. An alignment optical system controller 8 detects a positional shift of the reference mark SM with respect to the optical axis AX2. The wafer stage controller 10 moves the wafer stage 2 so that the reference mark SM is positioned on a reference axis AX1 of an electron lens system 22, based on the baseline decided in step S301. An electron optical system controller 7 scans the reference mark SM using an electron beam to detect a positional shift of the reference mark SM, and measures a baseline between the reference axis AX1 and optical axis AX2 again. In step S310, the wafer stage controller 10 moves the wafer stage 2 so that the alignment mark AM11 is positioned on the optical axis AX2 of the alignment optical system 4, based on the array regularity decided in step S303. The alignment optical system controller 8 detects a positional shift of the alignment mark AM11 with respect to the optical axis AX2. In step S311, the wafer stage controller 10 moves the wafer stage 2 so that the alignment mark AM11 is positioned on the reference axis AX1 of an electron optical system 1, based on the baseline measured again in step S309. The electron optical system controller 7 measures the position of the alignment mark AM11 using an electron beam while it is aligned with the reference axis AX1 of the electron optical system 1 using the baseline measured again, thereby detecting a positional shift of the alignment mark AM11 with respect to the reference axis AX1.

In step S312, the main controller 11 respectively calculates the amounts of drift of the electron beam for the alignment mark AM11 from the differences between the baseline measurement result obtained in step S309 and the measurement results obtained in steps S310 and S311. The main controller 11 calculates the amount of drift of the electron beam corresponding to the coordinate position of the wafer 6 using a function defined in the coordinate system on the wafer 6, based on the coordinate position of the alignment mark AM11 and the amounts of drift obtained for this mark. The main controller 11 issues a command to the electron optical system controller 7 or wafer stage controller 10 to adjust the position to which the electron beam is deflected or the position of the wafer stage 2, based on the calculated amount of drift, thereby correcting the drift of the electron beam. After the end of the calculation and correction of the amount of drift of the electron beam in step S312, the process returns to step S305, in which pattern drawing restarts. These drawing processes continue until drawing on all chips on the wafer 6 is completed in step S308. When drawing is complete in step S308, all the processes end.

In this embodiment, before the start of drawing, the alignment mark AM11 is selected from the plurality of alignment marks AM. The drawing operation is stopped a predetermined time after its start, and the positions of the reference mark SM and set alignment mark AM11 are sequentially measured using the alignment optical system 4 and an electron detector 24. After that, the amount of drift of the electron beam is calculated based on the position measurement results of the reference mark SM and alignment mark AM11. Therefore, the difference from the first embodiment lies in that baseline measurement is performed again at a predetermined timing after the start of drawing, and the main controller 11 calculates the amount of drift of the electron beam in consideration of the result of baseline measurement performed again. This makes it possible to precisely calculate the amount of drift of the electron beam resulting from charge-up of the electron optical system 1 and wafer 6, thereby aligning the electron beam and the wafer 6 with high accuracy. The reason for this will be described in detail below.

In this embodiment, in step S312, the main controller 11 calculates the amount of drift of the electron beam based on the position measurement results of the reference mark SM and alignment mark AM11 measured using the alignment optical system 4 and electron detector 24. The reference mark SM formed on an X stage 42 at a position different from that of the wafer 6 is less subject to, for example, deformation or expansion/contraction resulting from charge electrification and a change in temperature. Hence, the main controller 11 calculates the difference between the baseline measurement results obtained in steps S301 and S309 to calculate the amount of drift of the electron beam resulting from charge-up of the electron optical system 1. On the other hand, the difference between the measurement results of the alignment mark AM11 positioned on the periphery of the wafer 6, which are obtained by the electron optical system controller 7 and alignment optical system controller 8, includes the influence of charge-up of both the electron optical system 1 and the wafer 6. Hence, the amount of drift of the electron beam resulting from charge-up of the wafer 6 is calculated from the difference between the amount of drift of the electron beam calculated using the alignment mark AM11 and the previously obtained amount of drift of the electron beam resulting from charge-up of the electron optical system 1. Since the charge-up of the wafer 6 depends on the position on the wafer plane, the main controller 11 calculates the amount of drift of the electron beam corresponding to the coordinate position of the wafer 6 using a function defined in the coordinate system on the wafer 6, based on the coordinate position of the alignment mark AM11.

In the electron-beam exposure apparatus 100 according to this embodiment, the influence of charge-up of the wafer 6 differs depending on the position of the set alignment mark on the wafer 6, so the measurement accuracy may change. For example, when an alignment mark near the center of the wafer 6 is selected and set, charge-up of the wafer 6 has a small influence on the alignment mark, so the drift due to charge-up of the wafer 6 cannot be accurately corrected based on the reference mark SM and the alignment mark. Therefore, in the alignment mark setting (S304) of this embodiment, it is necessary to select and set an alignment mark positioned on the outer edge portion of the wafer 6, unlike the first and second embodiments. As for a method of correcting a drift of the electron beam in the electron-beam exposure apparatus 100, the same details as described in the first embodiment are applicable to the third embodiment intact, and a description thereof will not be given.

In the drift correction method according to this embodiment as well, the lapse of time between two position measurement operations for calculating the amount of drift can be shorter than the conventional methods described in Japanese Patent Laid-Open Nos. 2001-168013 and 2000-049069. This reduces the influence of deformation or expansion/contraction of the wafer 6 resulting from, for example, a change in temperature, thereby making it possible to measure and correct, with high accuracy, the amount of drift of the electron beam which changes with time. According to this embodiment, it is possible to provide an electron-beam exposure apparatus which can align the electron beam and the wafer 6 with high accuracy. Also, in this embodiment, the amount of drift of the electron beam resulting from charge-up of the electron optical system 1 is calculated from the measurement result of the reference mark SM which is less subject to, for example, deformation or expansion/contraction resulting from charge electrification and a change in temperature. This makes it possible to more accurately correct a drift of the electron beam than the first and second embodiment, in which an alignment mark which is positioned near the wafer 6 and is therefore less subject to charge-up of the wafer 6 is used. Although an alignment mark is set before the start of pattern drawing in this embodiment, the present invention is not limited to this. For example, the validity of alignment mark setting may be determined at a predetermined timing after the start of drawing, and thereupon a drift of the electron beam may be corrected.

### [Method of Manufacturing Device]

A method of manufacturing a device according to an embodiment of the present invention is suitable for manufacturing devices such as a semiconductor device and an FPD. The method can include a step of drawing a pattern on a substrate, coated with a photosensitive agent, using the above-mentioned electron-beam exposure apparatus, and a step of developing the substrate on which the pattern is drawn. The method of manufacturing a device can also include subsequent known steps (for example, oxidation, film formation, vapor deposition, doping, planarization, etching, resist removal, dicing, bonding, and packaging).

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.
An electron-beam exposure apparatus (100) includes a first measurement device (4) which irradiates a mark formed on a substrate (6) with light to detect reflected light of the light, thereby measuring the position of the mark, a second measurement device (24) which detects a secondary electron generated by the electron beam guided from an electron source (21) onto the mark, thereby measuring the position of the mark, and a controller (7, 8, 10, 11). The controller performs measurements for the mark using the first and second measurement devices without interposing drawing of a pattern on the substrate with the electron beam between the measurements, calculates a shift in irradiated point of the electron beam based on the difference between the measurement results obtained by the first and second measurement devices, and controls at least one of a stage (2) and the electron optical system to correct the calculated shift.

## Claims

1. An electron-beam exposure apparatus (100) which draws a pattern on a substrate (6) with an electron beam, **characterized by** comprising:
a stage (2) which holds a substrate;
an electron source (21) which emits an electron beam;
an electron optical system (1) which forms an image of the electron beam on a surface of the substrate;
a first measurement device (4) which irradiates a mark formed on the substrate with light to detect reflected light of the light with which the mark is irradiated, thereby measuring a position of the mark;
a second measurement device (24) which detects a secondary electron generated by the electron beam guided from said electron source onto the mark via said electron optical system, thereby measuring a position of the mark; and
a controller (7, 8, 10, 11),
wherein said controller
performs measurement for the mark using said first measurement device and measurement for the mark using said second measurement device without interposing drawing of a pattern on the substrate with the electron beam therebetween,
calculates a shift in irradiated point of the electron beam based on a difference between a measurement result of the mark obtained by said first measurement device and a measurement result of the mark obtained by said second measurement device, and
controls at least one of said stage and said electron optical system to correct the calculated shift in irradiated point of the electron beam.

2. The apparatus according to claim 1, **characterized in that** a mark which is not irradiated with the electron beam after the substrate is placed on said stage is selected as the mark formed on the substrate.

3. The apparatus according to claim 1, **characterized in that**
when said controller evaluates a calculation result of the shift in irradiated point of the electron beam on the substrate, and determines that the calculation result is inappropriate,
said controller
newly selects a different mark formed on the substrate, performs measurement for the different mark using said first measurement device and measurement for the different mark using said second measurement device,
newly calculates a shift in irradiated point of the electron beam based on a difference between a measurement result of the different mark obtained by said first measurement device and a measurement result of the different mark obtained by said second measurement device, and
controls at least one of said stage and said electron optical system to correct the newly calculated shift in irradiated point of the electron beam.

4. The apparatus according to claim 1, **characterized in that**
the mark includes a first mark formed on a peripheral portion of the substrate, and a second mark formed at a central portion of the substrate,
said first measurement device detects reflected light beams of light beams with which the first mark and the second mark are respectively irradiated, thereby measuring positions of the first mark and the second mark,
said second measurement device detects secondary electrons generated by electron beams with which the first mark and the second mark are respectively irradiated, thereby measuring positions of the first mark and the second mark,
said controller
performs measurement for the first mark and the second mark using said first measurement device and measurement for the first mark and the second mark using said second measurement device without interposing drawing of a pattern on the substrate with the electron beam therebetween,
calculates differences between measurement results of the first mark and the second mark obtained by said first measurement device and measurement results of the first mark and the second mark obtained by said second measurement device,
decides, from the calculated differences, a first component of a shift in irradiated point of the electron beam, which depends on the irradiated point, and a second component of the shift in irradiated point of the electron beam, which is independent of the irradiated point,
calculates a shift in irradiated point of the electron beam on the substrate, on which a pattern is to be drawn, based on the decided first component and second component, and
controls at least one of said stage and said electron optical system to correct the calculated shift in irradiated point of the electron beam,
the second component bears information on a shift in irradiated point of the electron beam resulting from charge-up of said electron optical system, and is expressed as the difference between the measurement result of the second mark obtained by said first measurement device and the measurement result of the second mark obtained by said second measurement device, and
the first component bears information on a shift in irradiated point of the electron beam resulting from charge-up of the substrate, and is expressed as a value obtained by subtracting the difference between the measurement result of the second mark obtained by said first measurement device and the measurement result of the second mark obtained by said second measurement device from the difference between the measurement result of the first mark obtained by said first measurement device and the measurement result of the first mark obtained by said second measurement device.

5. The apparatus according to claim 1, **characterized in that**
a reference mark is formed on said stage,
the mark is formed on a peripheral portion of the substrate,
said first measurement device detects reflected light beams of light beams with which the mark and the reference mark are respectively irradiated, thereby measuring positions of the mark and the reference mark with reference to a first reference,
said second measurement device detects secondary electrons generated by electron beams with which the mark and the reference mark are respectively irradiated, thereby measuring positions of the mark and the reference mark with reference to a second reference,
said controller
performs measurement for the reference mark using said first measurement device and measurement for the reference mark using said second measurement device to measure a baseline between the first reference and the second reference, and thereupon performs measurement for the mark using said first measurement device without interposing drawing of a pattern on the substrate with the electron beam between the measurements, and performs measurement for the mark using said second measurement device while the mark is aligned with the second reference using the measured baseline,
calculates a difference between a measurement result of the mark obtained by said first measurement device and a measurement result of the mark obtained by said second measurement device,
decides, from the calculated difference and the measured baseline, a first component of a shift in irradiated point of the electron beam, which depends on the irradiated point, and a second component of the shift in irradiated point of the electron beam, which is independent of the irradiated point,
calculates a shift in irradiated point of the electron beam on the substrate, on which a pattern is to be drawn, based on the decided first component and second component, and
controls at least one of said stage and said electron optical system to correct the calculated shift in irradiated point of the electron beam,
the second component bears information on a shift in irradiated point of the electron beam resulting from charge-up of said electron optical system, and is expressed as a difference between the measurement result of the reference mark obtained by said first measurement device and the measurement result of the reference mark obtained by said second measurement device, and
the first component bears information on a shift in irradiated point of the electron beam resulting from charge-up of the substrate, and is expressed as a value obtained by subtracting the difference between the measurement result of the reference mark obtained by said first measurement device and the measurement result of the reference mark obtained by said second measurement device from the difference between the measurement result of the mark obtained by said first measurement device and the measurement result of the mark obtained by said second measurement device.

6. A method of manufacturing a device, **characterized by** comprising:
drawing a pattern on a substrate using an electron-beam exposure apparatus defined in any one of claims 1 to 5;
developing the substrate on which the pattern is drawn; and
processing the developed substrate to manufacture the device.
